# EUROPEAN PATENT SPECIFICATION

(11) **EP 3 453 533 B1**
(45) Date of publication and mention of the grant of the patent: **27.05.2020**
(21) Application number: 17833290.4
(22) Date of filing: 04.05.2017
(51) Int. Cl.: B32B 38/16, B32B 41/00, H01J 37/32, B32B 15/08

(54) **VACUUM DRY PLATE CLEANING AND LAMINATING MACHINE**
VAKUUMTROCKENPLATTENREINIGUNGS- UND -LAMINIERMASCHINE
MACHINE DE NETTOYAGE ET DE STRATIFICATION DE PLAQUES SÈCHES SOUS VIDE

(30) Priority: 29.07.2016 CN 201610609985
(43) Date of publication of application: 13.03.2019
(73) Proprietor: Jiangyin Ruixing Technology Co., Ltd, Wuxi, Jiangsu 214406 (CN)
(72) Inventor: ZHANG, Guoxing, Wuxi Jiangsu 214406 (CN)
(74) Representative: Huang, Liwei
(86) International application number: PCT/CN2017/082995
(87) International publication number: WO 2018/018984

(56) References cited:
- EP-A1- 2 551 372
- CN-A- 101 348 896
- CN-A- 101 798 681
- CN-A- 106 079 843
- CN-U- 201 573 371
- CN-U- 201 648 515
- CN-U- 206 106 597

## Description

### Technical Field

The invention belongs to the technical field of production of laminated sheet material, and specifically relates to an in-line cleaning and laminating device for sheet material.

### Background Art

Coating sheet material is to cover the surface of a sheet material with a thin layer of metal by using a coating technique, so that the article has a metallic luster or achieves a certain functional characteristic. The functions of the functional metal coating include corrosion resistance, reflection, resistance to abrasion and wear, protection, electrical conduction, resistance to bacterial attack, and alternation of surface physical and chemical properties.

The surface of a conventional sheet material needs to be cleaned prior to laminating, so as to remove suspended impurities attached on the surface and passivation layers of metal oxide. At present, the cleaning of sheet material surface is predominantly chemical wet cleaning under atmospheric pressure. However, chemical cleaning has the environmental problem of discharging pollutant. In addition, chemical cleaning has disadvantages such as a long production line, a bad environment for operation, and a high consumption of energy.

Like solid, liquid, or gas, plasma is a state of substance. Gas will be converted to plasma state, when it is applied with energy sufficient to make it ionized. Active components of a plasma include: ions, electrons, active groups, nuclide in excited state (metastable state), photons, and so on. Plasma surface treatment technology is to treat the surface of a sample by using the "activation" of active particles in the plasma, so as to achieve the purpose of removing stains on the surface of an object. Performing surface plasma cleaning on the sheet material to be laminated so as to improve the cleaning and laminating effect represents a new application of plasma cleaning in the technical field of laminating. To develop a corresponding vacuum plasma cleaning and laminating device to realize the application of plasma in the field of laminating is a direction of endeavor for those skilled in the art.

Vacuum dry cleaning and laminating machines for sheet material of the background art are disclosed in documents CN 101798681 A and CN 201648515 U.

### Content of the Invention

The purpose of the invention is to provide a vacuum dry cleaning and laminating machine, which has a simple structure and realizes in-line plasma cleaning of the sheet material surface in a vacuum lamination production line, which improves the laminating effect and controls the discharge of pollutant in the production.

In order to solve the aforesaid problem, the technical solution adopted by the present invention is a vacuum dry cleaning and laminating machine, comprising a vacuum unwinding chamber, a vacuum cleaning channel, a vacuum laminating chamber and a vacuum winding chamber, which are arranged sequentially, wherein a plasma cleaning device is arranged inside the vacuum cleaning channel, and it emits plasma beams onto the sheet material surface for cleaning when the to-be-laminated sheet material from the vacuum unwinding chamber passes through the vacuum cleaning channel, wherein the vacuum cleaning channel is provided with an opening for vacuum gas extraction ; a laminating means is arranged inside the vacuum laminating chamber, and the surface of the sheet material from the vacuum cleaning channel is laminated by the laminating means; the laminated sheet material is wound up in the vacuum winding chamber.

The above-mentioned laminating means can perform laminating on one or both sides of the sheet material.

Preferably, more than one group of brush rollers for cleaning the sheet material surface is arranged at the front end of the vacuum cleaning channel.

Preferably, a high-frequency heater for heating the sheet material is arranged at the outlet of the vacuum unwinding chamber to heat the sheet material surface. Heating the sheet material surface before the plasma cleaning facilitates not only a better removal of impurities on the metal surface but also the lamination of the film on the cleaned sheet material. Thus, the film is applied flat onto the sheet material surface.

Specifically, the laminating means comprises a film releasing roll, a film guiding roller, a film adsorbing/releasing roller, a laminating pressure roller and a turning roller. Being guided by the film guiding roller, the film released from the film releasing roll is conveyed to the film adsorbing/releasing roller, wherein the film adsorbing/releasing roller can reliably adsorb the film before the start of lamination and apply the film onto the sheet material surface after the start of operation, and the film can be pressed by the laminating pressure roller onto the sheet material surface. Finally, the laminated sheet material is guided via the turning roller into the vacuum winding chamber to complete the winding.

Said film adsorbing/releasing roller comprises a mandrel and an outer roller sleeve set on the mandrel, wherein the outer roller sleeve is rotatable relative to the mandrel, and inside the mandrel there is an adsorbing core chamber and a blowing core chamber that are independent of each other, the edge of the mandrel corresponding to the adsorbing core chamber is provided with several adsorbing openings, and the edge of the mandrel corresponding to the blowing core chamber is provided with several blowing openings, and the roller surface of the outer roller sleeve is provided with mesh holes.

Compared with the prior art, the present invention has the following advantages: it provides a vacuum dry cleaning and laminating machine, wherein the entire laminating operation line is arranged inside in a closed vacuum chamber so as to be adapt to the high vacuum operation environment required for plasma cleaning, wherein volatile substances generated during the cleaning process are discharged from the vacuum gas extraction opening. The entire device has a compact structure; it cleans sheet material by using plasma without discharge of waste water, and therefore meets environmental friendly operation standards of modern production.

### Brief Description of the Drawings

FIG. 1 is a schematic structural view of a vacuum dry cleaning and laminating machine according to an embodiment of the present invention;
FIG. 2 is a schematic structural view of a film adsorbing/releasing roller according to an embodiment of the present invention.

### Embodiments

The present invention will be further described in detail with reference to the accompanying drawings.

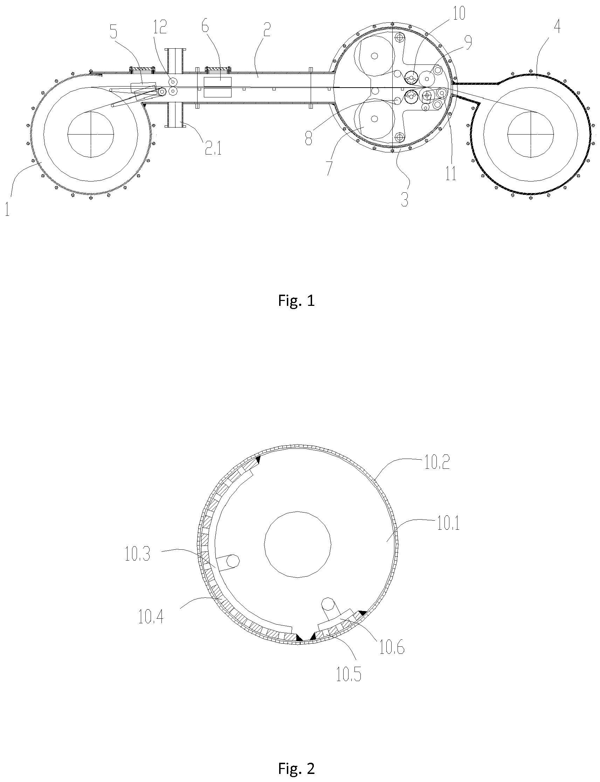

As shown in FIG. 1 and FIG. 2, the vacuum dry cleaning and laminating machine in this embodiment comprises a vacuum unwinding chamber 1, a vacuum cleaning channel 2, a vacuum laminating chamber 3 and a vacuum winding chamber 4, which are arranged sequentially, a high-frequency heater 5 for heating the sheet material is arranged at the outlet of the vacuum unwinding chamber 1 to heat the sheet material surface; more than one group of brush rollers 12 for cleaning the sheet material surface is arranged at the front end of the vacuum cleaning channel 2. A plasma cleaning device 6 is arranged inside the vacuum cleaning channel 2, and it emits plasma beams onto the sheet material surface for cleaning when the to-be-laminated sheet material from the vacuum unwinding chamber 1 passes through the vacuum cleaning channel 2, wherein the vacuum cleaning channel 2 is provided with an opening for vacuum gas extraction 2.1; a laminating means is arranged inside the vacuum laminating chamber 3, and the surface of the sheet material from the vacuum cleaning channel 2 is laminated by the laminating means; the laminated sheet material is wound up in the vacuum winding chamber 4.

The laminating means comprises a film releasing roll 7, a film guiding roller 8, a film adsorbing/releasing roller 10, a laminating pressure roller 9 and a turning roller 11. Being guided by the film guiding roller 8, the film released from the film releasing roll 7 is conveyed to the film adsorbing/releasing roller 10, wherein the film adsorbing/releasing roller 10 can reliably adsorb the film before the start of lamination and blow the film onto the sheet material surface after the start of operation, and the film can be pressed by the laminating pressure roller 9 onto the sheet material surface, and the laminated sheet material is guided via the turning roller 11 into the vacuum winding chamber 4 to complete the winding.

Specifically, the film adsorbing/releasing roller 10 comprises a mandrel 10.1 and an outer roller sleeve 10.2 set on the mandrel 10.1, wherein the outer roller sleeve 10.2 is rotatable relative to the mandrel 10.1, and inside the mandrel 10.1 there is an adsorbing core chamber 10.3 and a blowing core chamber 10.6 that are independent of each other, the edge of the mandrel 10.1 corresponding to the adsorbing core chamber 10.3 is provided with several adsorbing openings 10.4, and the edge of the mandrel 10.1 corresponding to the blowing core chamber 10.6 is provided with several blowing openings 10.5, and the roller surface of the outer roller sleeve 10.2 is provided uniformly with mesh holes.

The vacuum plasma cleaning and laminating machine of above-mentioned structure realizes the application of plasma cleaning in the metal lamination production line for cleaning sheet material, has a compact structure, improves the production efficiency for cleaning and laminating sheet material, shortens the operation process, saves energy and is environmental friendly.

In addition to the aforesaid embodiments, the present invention further includes other embodiments. Any technical solution formed by equivalent transformation or equivalent substitution shall fall within the protection scope of the claims of the present invention.

## Claims

1. A vacuum dry cleaning and laminating machine for sheet material, the laminating machine comprising a vacuum unwinding chamber (1), a vacuum cleaning channel (2), a vacuum laminating chamber (3) and a vacuum winding chamber (4), which are arranged sequentially, wherein a plasma cleaning device(6) is arranged inside the vacuum cleaning channel (2), and it emits plasma beams onto the sheet material surface for cleaning when the to-be-laminated sheet material from the vacuum unwinding chamber (1) passes through the vacuum cleaning channel (2), wherein the vacuum cleaning channel (2) is provided with an opening for vacuum gas extraction (2.1); a laminating means is arranged inside the vacuum laminating chamber, so that the surface of the sheet material coming from the vacuum cleaning channel (2) is laminated by the laminating means; the laminated sheet material is wound up in the vacuum winding chamber (4),
wherein the laminating means comprises a film releasing roll (7), a film guiding roller (8), a film adsorbing/releasing roller (10), a laminating pressure roller (9) and a turning roller (11); being guided by the film guiding roller (8), the film released from the film releasing roll (7) is conveyed to the film adsorbing/releasing roller (10), wherein the film adsorbing/releasing roller (10) is able to reliably adsorb the film before the start of laminating and apply the film onto the sheet material surface after the start of operation, and the applied film can be pressed by the laminating pressure roller onto the sheet material surface; finally, the laminated sheet material is guided via the turning roller (11) into the vacuum winding chamber (4) to complete the winding;
**characterized in that** the film adsorbing/releasing roller comprises a mandrel (10.1) and an outer roller sleeve (10.2) set on the mandrel (10.1), wherein the outer roller sleeve (10.2) is rotatable relative to the mandrel (10.1), and inside the mandrel (10.1) there is an adsorbing core chamber (10.3) and a blowing core chamber (10.6) that are independent of each other, the edge of the mandrel (10.1) corresponding to the adsorbing core chamber (10.3) is provided with several adsorbing openings (10.4), and the edge of the mandrel (10.1) corresponding to the blowing core chamber (10.6) is provided with several blowing openings (10.5), and the roller surface of the outer roller sleeve (10.2) is provided uniformly with mesh holes.

2. The vacuum dry cleaning and laminating machine for sheet material according to claim 1, **characterized in that**, a high-frequency heater for heating the sheet material is arranged at the outlet of the vacuum unwinding chamber.

3. The vacuum dry cleaning and laminating machine for sheet material according to claim 1, **characterized in that**, more than one group of brush rollers (12) for cleaning the sheet material surface is arranged at the front end of the vacuum cleaning channel (2).

4. The vacuum dry cleaning and laminating machine for sheet material according to claim 1, **characterized in that**, the laminating means can perform laminating on one or both sides of the sheet material.

## Patentansprüche

1. Trockensaug- und Laminiergerät für Bahnware, wobei das Laminiergerät aufweist:
eine Vakuumabwickelkammer (1), einen Absaugkanal (2), eine Vakuum-Laminierkammer (3) und eine Vakuumwickelkammer (4), die hintereinander angeordnet sind, wobei eine Plasmareinigungsvorrichtung (6) innerhalb des Absaugkanals (2) angeordnet ist und sie Plasmastrahlen auf die Oberfläche der Bahnware zur Reinigung richtet, wenn die zu laminierende Bahnware aus der Vakuumabwickelkammer (1) durch den Absaugkanal (2) läuft, wobei der Absaugkanal (2) mit einer Öffnung zur Vakuumgasextraktion (2.1) versehen ist; wobei eine Laminiereinrichtung innerhalb der Vakuum-Laminierkammer (3) derart angeordnet ist, dass die Oberfläche der aus dem Absaugkanal (2) kommenden Bahnware durch die Laminiereinrichtung laminiert wird; wobei die laminierte Bahnware in der Vakuumwickelkammer (4) aufgewickelt wird,
wobei die Laminiereinrichtung eine Filmabrollwalze (7), eine Filmführungsrolle (8), eine Filmaufnahme-/-abrollwalze (10), eine Laminierdruckwalze (9) und eine Drehrolle (11) aufweist; unter der Führung durch die Filmführungsrolle (8) wird der von der Filmabrollwalze (7) abgerollte Film zu der Filmaufnahme-/- abrollwalze (10) hin befördert, wobei die Filmaufnahme-/-abrollwalze (10) in der Lage ist, den Film zuverlässig aufzunehmen, bevor das Laminieren beginnt, und den Film nach dem Start des Betriebs auf die Oberfläche der Bahnware aufzubringen, und dann kann der aufgebrachte Film von der Laminierdruckwalze auf die Oberfläche der Bahnware gepresst werden; schließlich wird die laminierte Bahnware über die Drehrolle (11) in die Vakuumwickelkammer (4) geführt, um die Aufwicklung zu vollenden;
**dadurch gekennzeichnet, dass** die Filmaufnahme-/-abrollwalze (10) einen Spanndorn (10.1) und eine auf dem Spanndorn (10.1) angeordnete äußere Rollenhülse (10.2) aufweist, wobei die äußere Rollenhülse (10.2) drehbar gegenüber dem Spanndorn (10.1) ausgebildet ist, und wobei sich innerhalb des Spanndorns (10.1) eine Aufnahmekernkammer (10.3) und eine Blaskernkammer (10.6) befinden, die voneinander unabhängig ausgebildet sind, wobei die Kante des Spanndorns (10.1), welche der Aufnahmekernkammer (10.3) entspricht, mit mehreren Aufnahmeöffnungen (10.4) versehen ist und die Kante des Spanndorns (10.1), welche der Blaskernkammer (10.6) entspricht, mit mehreren Blasöffnungen (10.5) versehen ist, und wobei die Rollenoberfläche der äußeren Rollenhülse (10.2) gleichmäßig mit Netzöffnungen versehen ist.

2. Trockensaug- und Laminiergerät für Bahnware gemäß Anspruch 1, **dadurch gekennzeichnet, dass** ein Hochfrequenz-Heizgerät zum Erhitzen der Bahnware am Ausgang der Vakuumabwickelkammer angeordnet ist.

3. Trockensaug- und Laminiergerät für Bahnware gemäß Anspruch 1, **dadurch gekennzeichnet, dass** mehr als eine Gruppe von Bürstenwalzen(12) zum Reinigen der Oberfläche der Bahnware am vorderen Ende des Absaugkanals (2) angeordnet ist.

4. Trockensaug- und Laminiergerät für Bahnware gemäß Anspruch 1, **dadurch gekennzeichnet, dass** die Laminiereinrichtung die Laminierung auf einer oder auf beiden Seiten der Bahnware durchführen kann.

## Revendications

1. Machine de nettoyage à sec par aspiration et de laminage pour des matériaux en feuilles, la machine de laminage comprenant :
une chambre de déroulage sous vide (1), un canal de nettoyage par aspiration (2), une chambre de laminage sous vide (3) et une chambre d'enroulage sous vide (4), qui sont disposés l'un après l'autre, dans lequel un dispositif de nettoyage de plasma (6) est disposé à l'intérieur du canal de nettoyage par aspiration (2) et il émet des faisceaux de plasma sur la surface des matériaux en feuilles pour nettoyer, quand les matériaux en feuilles à laminer venant de la chambre de déroulage sous vide (1) passent à travers le canal de nettoyage par aspiration (2), dans lequel le canal de nettoyage par aspiration (2) est muni d'une ouverture destinée à l'extraction de gaz sous vide (2.1) ; un moyen de laminage étant disposé à l'intérieur de la chambre de laminage sous vide (3), de sorte que la surface des matériaux en feuilles venant du canal de nettoyage par aspiration (2) est laminée par le moyen de laminage ; les matériaux en feuilles laminés sont ensuite enroulés dans la chambre d'enroulage sous vide (4),
dans lequel le moyen de laminage comprend un rouleau de déroulage de film (7), un rouleau de guidage de film (8), un rouleau de réception/déroulage de film (10), un rouleau de pression de laminage (9) et un rouleau de rotation (11) ; sous le guidage du rouleau de guidage de film (8) le film déroulé du rouleau de déroulage de film (7) est transporté au rouleau de réception/déroulage de film (10), dans lequel le rouleau de réception/déroulage de film (10) est capable de recevoir de manière fiable le film avant le début du laminage et d'appliquer le film sur la surface des matériaux en feuilles après la mise en opération, et le film appliqué peut être pressé par le rouleau de pression de laminage (9) sur la surface des matériaux en feuilles ; et finalement les matériaux en feuilles laminés sont guidés via le rouleau de rotation (11) dans la chambre d'enroulage sous vide (4) pour terminer l'enroulage ;
**caractérisée en ce que** le rouleau de réception/déroulage de film comprend un mandrin (20.1) et une gaine extérieure de rouleau (10.2) disposée sur le mandrin (10.1), dans lequel la gaine extérieure de rouleau (10.2) est rotative par rapport au mandrin (10.1), et à l'intérieur du mandrin (10.1) se trouvent une chambre de noyau de réception (10.3) et une chambre de noyau d'aspiration (10.6), qui sont indépendantes l'une de l'autre ; le bord du mandrin (10.1) correspondant à la chambre de noyau de réception (10.3) est muni de plusieurs ouvertures de réception (10.4) et le bord du mandrin (10.1) correspondant à la chambre de noyau d'aspiration (10.6) est muni de plusieurs ouvertures d'aspiration (10.5) et la surface de rouleau de la gaine extérieure de rouleau (10.2) est munie de manière uniforme de trous de maillage.

2. Machine de nettoyage à sec par aspiration et de laminage pour des matériaux en feuilles selon la revendication 1, **caractérisée en ce qu'**un radiateur à hautes fréquences pour chauffer les matériaux en feuilles est disposé à la sortie de la chambre de déroulage sous vide.

3. Machine de nettoyage à sec par aspiration et de laminage pour des matériaux en feuilles selon la revendication 1, **caractérisée en ce que** plus d'un groupe de rouleaux de brosse (12) pour nettoyer la surface des matériaux en feuilles est disposé à l'extrémité avant du canal de nettoyage par aspiration (2).

4. Machine de nettoyage à sec par aspiration et de laminage pour des matériaux en feuilles selon la revendication 1, **caractérisée en ce que** le moyen de laminage peut effectuer le laminage sur un ou sur les deux côtés des matériaux en feuilles.
